(19) Europäisches Patentamt
European Patent Office
Office européen des brevets

(11) EP 0 526 039 B1

(12) **EUROPEAN PATENT SPECIFICATION**

(45) Date of publication and mention
of the grant of the patent:
**30.09.1998 Bulletin 1998/40**

(51) Int Cl.⁶: **G03B 41/00**, G03F 7/20

(21) Application number: **92306476.0**

(22) Date of filing: **15.07.1992**

(54) **Method for exposing a pattern plate having an alignment pattern**

Verfahren zur Belichtung einer Modellplatine mit Ausrichtmuster

Procédé d'exposition d'une plaque modèle ayant une cible d'alignement

(84) Designated Contracting States:
**DE FR GB**

(30) Priority: **18.07.1991 JP 177871/91**

(43) Date of publication of application:
**03.02.1993 Bulletin 1993/05**

(73) Proprietor: **DAI NIPPON PRINTING CO., LTD.
Tokyo 162 (JP)**

(72) Inventors:
• **Shinoda, Toshiki, c/o Dai Nippon Print Co., Ltd.
  Tokyo 162 (JP)**
• **Takezawa, Tetsuo, c/o Dai Nippon Print Co., Ltd.
  Tokyo 162 (JP)**
• **Noguchi, Shigeru, c/o Dai Nippon Print Co., Ltd.
  Tokyo 162 (JP)**

(74) Representative: **Dixon, Donald Cossar et al
Gee & Co.
Chancery House
Chancery Lane
London WC2A 1QU (GB)**

(56) References cited:
**DE-A- 3 118 802**

• **PATENT ABSTRACTS OF JAPAN vol. 13, no. 92
  (E-722)3 March 1989 & JP-A-63 269 526
  ( CANON ) 7 November 1988**
• **PATENT ABSTRACTS OF JAPAN vol. 14, no. 244
  (E-932)24 May 1990 & JP-A-02 067 713 ( CANON )
  7 March 1990**
• **PATENT ABSTRACTS OF JAPAN vol. 15, no. 379
  (E-1115)25 September 1991 & JP-A-03 151 624
  ( CANON ) 27 June 1991**

## Description

The present invention relates to a method for producing a pattern plate having an alignment pattern (mark) for position alignment, and in particular to a method for producing a large size pattern plate used for a reticle mask or shadow mask and for producing patterns by projecting onto a wafer and master mask substrate, and also to a pattern plate exposed by said method.

In recent years, ICs and LSIs have become more and more highly integrated, and DRAMs of 4M bits are already manufactured on mass production, shifting now toward 16M bits and 64M bits. As the result, there are strong requirements for higher miniaturization of circuit elements on wafers. Such miniaturization is also wanted in the preparation of patterns by lithography technique to provide circuit elements on wafers.

In general, there are the following three methods to prepare patterns on wafers: The first method is to use an EB (electron beam) system or FIB (focusing ion beam) system, and patterns are formed directly on a wafer by controlling the electron beam or ion beam. In this case the exposing position is controlled to match the pattern on the wafer, and the patterning accuracy depends only on the position detecting ability and exposure position control ability. Some problems remain with this position detecting ability and the position control ability. Because the patterns are formed one by one in this method and it takes much time, this is not very suitable for mass production.

In the second method, a mask is used, which has a plurality of mask patterns, i.e. patterns of the same size as the pattern of each chip to be formed on the wafer, and this is transferred onto a wafer substrate. This is suitable for mass production because entire exposure at once is used. Since transfer is performed at 1:1 magnification, positioning accuracy with the pattern on the wafer is cumulated on pattern alignment accuracy. The distortion of the master mask also gives direct influence on the accuracy.

Examples of processes of exposing a wafer using a mask, or pattern plate, are also described in DE-A-31 18 802, and Patent Abstract of Japan, vol. 14, No. 244, (E-932), 24 May 1990, & JP-A-02 067 713 (CANON), 7 March 1990.

The third method uses a mask called a reticle mask with a pattern 5-10 times larger than the pattern of the wafer or the master mask, and this is exposed by reduced projection on wafer substrate. Because this method is based on reduced projection, positioning (overlapping) accuracy error between the pattern on wafer and the pattern on the reticle mask is also reduced, and higher accuracy is provided. Also, this is more advantageous than the methods using EB or FIB in production, because the entire exposure is performed at once.

As described above, the progress in the technique of IC and LSI elements toward higher integration further necessitates higher miniaturization of the pattern on the wafer. As the result, there are strong demands on higher overlapping accuracy (positioning accuracy) between the pattern on the wafer and the pattern to be prepared.

Under such circumstances, in the reduced projection exposure method, which is a third pattern preparation procedure advantageous in its overlapping accuracy with wafer pattern, there are strong requirements on the accuracy higher than the overlapping accuracy of the current level (0.04 - 0.2 $\mu$m). In the case of DRAM, it is essential to have overlapping accuracy of 0.02 - 0.01 $\mu$m at 16M bit level. In this method, 10 or more reticle masks are normally needed to prepare an LSI, and it is required to have overlapping accuracy of less than 0.02-0.01 $\mu$m between the patterns of reduced projection.

In the fields of color television and display, the products are becoming increasingly larger in recent years, and shadow masks and liquid crystal panels are also becoming larger. For pattern plates of shadow masks and liquid crystal panels, there are demands not only for larger size products but miniaturization (finer size). When an optical exposure system is used, aperture exposure to obtain a desired pattern for a combination of picture pattern corresponding to the aperture is performed more frequently, and the entire exposure time becomes longer accordingly, often lasting for 24 hours. Further, when an electron beam exposure system is used, a long time is required because of dependency on area in a raster scanning type system for exposing a pattern through combination of raster scanning and blanking. When a vector type system is used for vector scanning of a variable shaped beam, scanning is performed corresponding to the aperture as in the case of the optical exposure system, and the time for exposure becomes longer.

When the reticle pattern is prepared by an electron beam exposure system, a raster scanning type system is normally used. With a mask substrate fixed on stage, the stage is moved under position control system based on a laser interferometer, and the substrate is exposed to irradiation of an electron beam, and the desired picture pattern is depicted by exposure. The electron beam is irradiated under deflection control and is blanked and unblanked for each predetermined address on the substrate. However, to prepare finer pattern with high precision, it is necessary to decrease address size, which is a unit for exposure, and the time for exposure is extensively increased.

In a vector type electron beam exposure system, desired aperture images are irradiated by the beam, and a pattern is prepared by combining such images. To prepare finer pattern with high precision, it is necessary to decrease aperture diameter. This also means that an extensively long time is required for exposure.

As described above, when longer time is required for exposure of finer pattern, the following problems become important issues in a system with precision control such as an electron beam exposure system: (1) temperature change on the substrate to be exposed; (2) electrical change; (3) mechanical change; and (4) fluctuation in position control system. In particular, in case of a pattern plate having alignment pattern such as reticle mask, it is necessary that the positional relationship between an alignment pattern and a device pattern is precisely arranged in order to control the position of the device pattern by the alignment pattern based on accurate positional relationship between the alignment pattern and the device pattern. Such relationship is also influenced by the above factors (1) - (4). Similarly, the pattern plates for shadow mask and liquid crystal panel are also influenced by the above (1) - (4).

In most cases, the changes and fluctuations in the above (1) - (4) are mono-directional. Factor (1) is considered as caused by the difference between the temperature of the substrate itself and the environmental temperature of the stage to be used. (2) is caused by electric drift, and (3) results from the cassette to fix the substrate to be exposed, mainly from gradual deviation of the cassette during X and Y shifting of the stage. (4) is caused by the change of environmental barometric pressure and temperature of the interferometer. In general, most of (1) and a part of (2) - (4) are influenced by exposure size of the substrate and are approximately proportional to the dimension of the device pattern, and most of (2) - (4) are influenced by exposure time. In any case, the cases are divided to positional deviation (error) proportional to depiction size and generated according to pattern size and the positional deviation generated in proportion to exposure time. In particular, the deviation caused by (2) - (4) becomes an issue. If this deviation is large, it leads to incorrect relationship between the alignment pattern and the device pattern. The positional deviation generated according to the pattern size is considered to be relatively small.

To solve the above problems, it is an object of the present invention to provide a method for exposing a pattern plate, i.e. forming a pattern plate comprising a substrate bearing a latent image of a device pattern and a latent image of an alignment pattern, wherein exposure can be performed with highly accurate positional relationship between the alignment pattern and the device pattern.

This object is achieved by the features of Claim 1.

Still other objects and advantages of the invention will in part be obvious and will in part be apparent from the specification. The invention accordingly comprises the features of construction, combinations of elements, and arrangement of parts which will be exemplified in the construction hereinafter set forth.

In the accompanying drawings:

Fig.1 is a plan view for explaining the order to expose a reticle mask according to an embodiment of the present invention;

Fig.2 is a plan view of an entire reticle mask for explaining a principle to correct relative positional deviation between an alignment pattern and a device pattern according to the present invention;

Fig. 3 is a partial view of a part of an alignment pattern similar to Fig. 2; and

Fig. 4 is a partial view of an alignment pattern of another example similar to Fig. 2.

In the following, description will be given on a method for exposing pattern plate having an alignment pattern of the present invention in connection with the drawings, taking an example of a case where it is applied to a reticle mask.

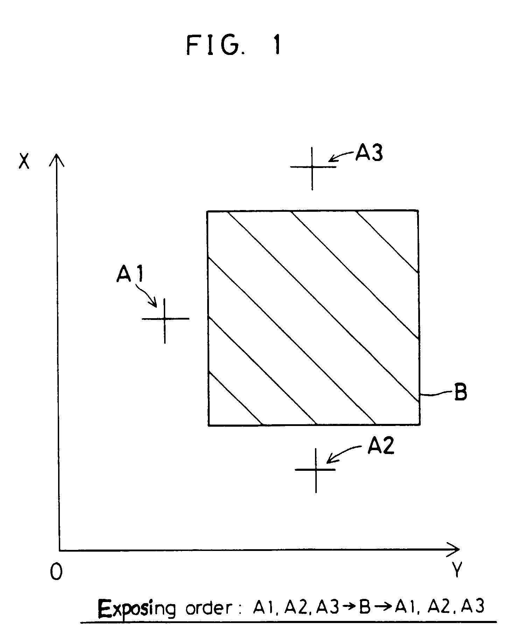

As shown in the plan view of Fig. 1, when a pattern plate is produced, which has a device pattern B, and alignment patterns A1, A2 and A3 around B, passing through the centers in X direction and Y direction of the device pattern B, a position control system such as a laser interferometer, and X and Y stage driving system are used. Exposure is performed by an electron beam exposure system in the following procedure using an electron beam exposure system or an optical exposure system. First, the alignment patterns A1, A2 and A3 are exposed, and the device pattern B is then exposed. Next, the alignment patterns A1, A2 and A3 are again exposed by overlap-exposing on the first exposure.

Through exposure of the alignment patterns A1, A2 and A3 before and after exposing the device pattern B, the accuracy of positional relationship between the alignment patterns A1, A2 and A3 on one side and the device pattern B on the other side can be improved. In particular, it is possible to almost perfectly correct relative positional deviation (i.e., the error from the predetermined value on distance) between the alignment patterns and the device pattern caused by changes of the above (2) - (4) during the exposure of the device pattern, and to alleviate the getting worse of positional accuracy in the exposure caused by the above (1), (4), etc.

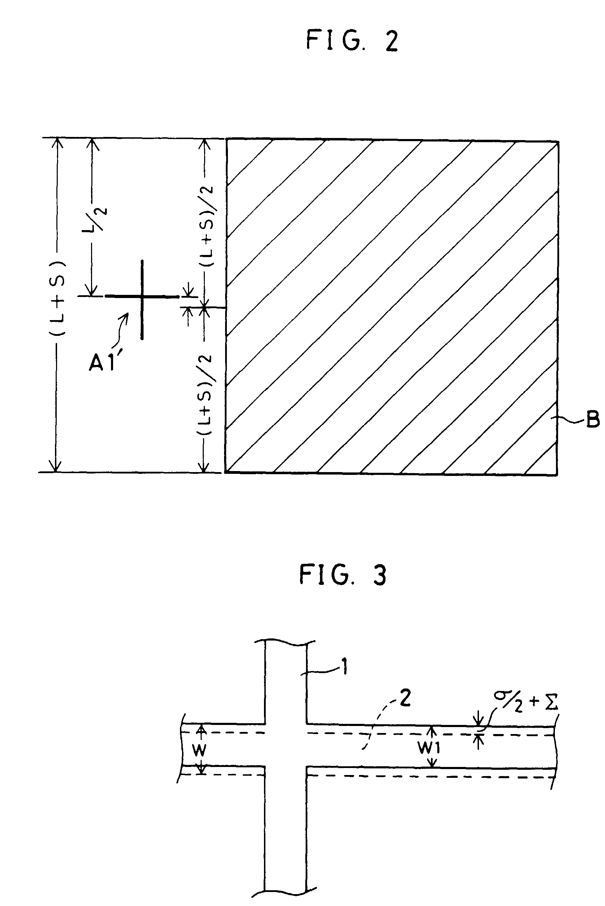

Referring to Fig. 2 and Fig. 3, description will be given on the principle to correct relative positional deviation between the alignment patterns and the device pattern through exposure of the alignment patterns A1, A2 and A3 before and after exposing the device pattern B. For easier explanation, description will be given on positional deviation in the X direction only, but the same applies to Y direction.

As shown in Fig. 2, it is supposed that the design dimension of the device pattern B is L and actual exposing dimension is L + s. If it is considered that the deviation s is a sum of the deviation $\sigma$ approximately proportional to pattern dimension and the deviation $\Sigma$ approximately proportional to exposure time, the positional deviation $\Delta 1$ between alignment pattern A1' exposed at first and the center of a device pattern B exposed secondly is given by:

$$\Delta1 \fallingdotseq (L + s)/2 - L/2 = s/2 = (\sigma + \Sigma)/2$$

As shown in Fig. 3, if it is supposed that line width at the first exposure of the alignment pattern is W1, the deviation between the line 1 exposed at first and the line 2 exposed secondly is: $\sigma/2 + \Sigma$. Therefore, the width line W of the entire alignment patterns exposed twice is: W1 + $\sigma/2 + \Sigma$. Accordingly, the positional deviation 2 between the center of the line 1 exposed at first and the center of the line of the entire alignment pattern A1 is given by:

$$\Delta2 \fallingdotseq (W1 + \sigma/2 + \Sigma)/2 - W1/2 = \sigma/4 + \Sigma/2$$

Thus, the positional deviation $\Delta$ between the center of the alignment pattern A1 prepared in overlap exposures and the center of the device pattern B is given by:

$$\Delta \fallingdotseq \Delta1 - \Delta2 = (\sigma + \Sigma)/2 - (\sigma/4 + \Sigma/2) = \sigma/4$$

Specifically, if the method according to the present invention is compared with the conventional method, by which the alignment pattern is not exposed by overlap-exposure and it is exposed only once either before and after exposing the device pattern B, the distance between the center of the alignment pattern A1 and the center of the device pattern B is deviated only by $\Delta \fallingdotseq \sigma/4$ in case of the present invention, and the positional deviation $\Sigma$ depending upon the exposure time is not involved. In the conventional case, it is deviated by $\Delta1 \fallingdotseq (\sigma + \Sigma)/2$. The deviation proportional to pattern dimension is approximately two times of the case of the present invention. Further, there is positional deviation depending upon the exposure time, and this is the deviation corresponding to one-half of the entire exposure time. That is, it is possible according to the present invention to almost perfectly correct relative positional deviation $\sigma/2$ between the alignment patterns and the device pattern caused by the changes of (2) - (4) during exposure of the device pattern, and also to reduce the getting worse of positional accuracy $\sigma/2$ of exposure caused by (1), (4), etc. to about one-half.

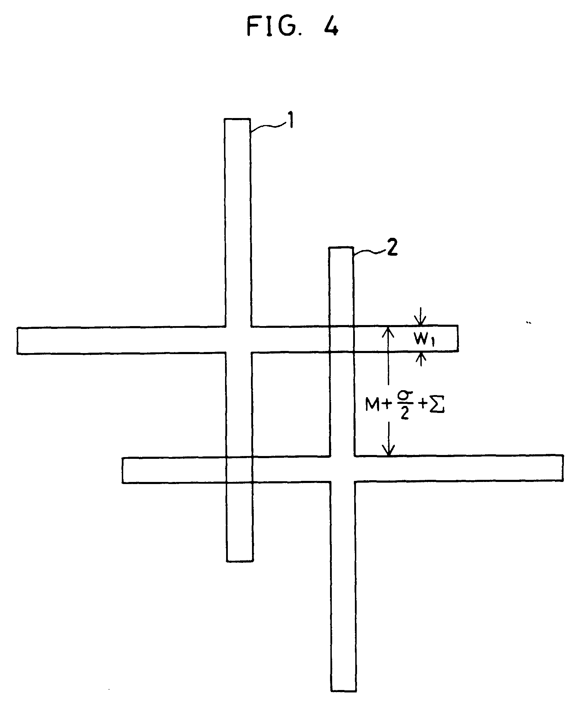

When a first exposing position and a second exposing position of the alignment pattern are deviated by a certain distance M in design as shown in Fig. 4, it is possible to almost perfectly correct relative positional deviation $\Sigma/2$ between the alignment pattern and the device pattern caused by the changes of (2) - (4) during exposure of the device pattern and to reduce the worsening of the positional accuracy /2 of exposure caused by (1), (4), etc. to approximately one-half.

As described above, according to the method for exposing pattern plate of the present invention, alignment patterns are prepared by overlap-exposing before and after exposing device pattern. Using an intermediate position of overlapped alignment pattern (overlap exposed alignment pattern) as the central position of the alignment pattern, the deviation of the alignment pattern is controlled in accordance with the deviation of the device pattern, and the deviation from the predetermined value of the positional relationship with the center of the device pattern is corrected. As it is evident from the principle, the method for exposing an alignment mark according to the present invention is suitable for a pattern plate used for reticle mask of a highly integrated semiconductor device, and also for the pattern plates for large size high density shadow mask, which have large size device pattern and complicated pattern requiring much time to expose.

In rare cases where the direction of the changes of the above (1) - (4) is not constant, it is advised not to restrict exposure of the alignment pattern to before and after exposing the device pattern, and it may be performed a few times during exposure of the device pattern.

In the above explanations for Fig. 1 to Fig. 4 description has been given on a reticle mask for semiconductor exposure having alignment patterns around it, while the method of the present invention can also be applied for exposure of shadow mask pattern plate having alignment pattern for positioning and electrode pattern plates for liquid crystal panel.

As described above, according to the exposing method of pattern plate having alignment pattern and the pattern plate exposed by the method of the present invention, alignment patterns are exposed at least before exposing the device pattern, and alignment patterns are prepared by overlap-exposing the alignment patterns after exposing the device pattern. Thus, compared with the conventional case where the alignment pattern is prepared by exposing only once before or after exposing the device pattern, it is possible to almost perfectly correct relative positional deviation between the alignment pattern and the device pattern, changing depending upon exposure time during exposing of the device pattern, and to reduce the worsening of positional accuracy of depiction changing due to pattern size.

Therefore, it is possible:

(1) to carry out the production with high positional accuracy between the alignment pattern and the device pattern, and to achieve the better production;

(2) to provide a exposure method for controlling positional accuracy between the alignment pattern and the device pattern and to cope with the changes such as temperature change, electrical change, mechanical change of substrate and the change of position control system during exposure; and

(3) to provide a exposure method for controlling positional accuracy between the alignment pattern and the device pattern caused by exposure time and the size even in case of large size pattern such as shadow mask original plate.

## Claims

1. A method of producing a pattern plate from a substrate, including the steps of exposing the substrate to an image (1) of an alignment pattern (A1,A2,A3) by scanning said substrate with an electron beam or a light beam; thereafter exposing said substrate to an image of a device pattern (B)by scanning said substrate with an electron beam or a light beam; and repeating the step of exposing said substrate to an image (2) of said alignment pattern (A1,A2,A3), whereby two images (1,2) of said alignment pattern having the same configuration are exposed on said substrate in at least partially superimposed relationship, so that said two images (1,2) of said alignment pattern are relatively displaced in a direction and by a distance corresponding to the cumulative positional error arising in the scanning system during the scanning processes by which said substrate is exposed to said images (1,2,B), thereby minimizing positional deviations between the alignment pattern and the device pattern.

2. A method as claimed in Claim 1, wherein the shape and configuration of said images of said alignment pattern is such that in a finished pattern plate, the superimposed alignment patterns form a composite alignment pattern from which can be determined a positional error in relation to the said device pattern that represents a mean value of said cumulative error.

3. A method as claimed in Claim 1 or 2, wherein the step of exposing said substrate to an image of said alignment pattern is also repeated at least once during the step of exposing the substrate to said image of the device pattern, whereby at least three images of an alignment pattern are formed in at least partially superimposed relationship in the finished pattern plate.

4. A method as claimed in any one of Claims 1-3, wherein the pattern plate formed by the method is a plate of reticle pattern.

5. A method as claimed in any one of Claims 1-3, wherein the pattern plate formed by the method is a plate of shadow mask pattern.

6. A method as claimed in any one of Claims 1-3, wherein the pattern plate formed by the method is an electrode pattern plate for a liquid crystal panel.

## Patentansprüche

1. Verfahren zur Herstellung einer Musterplatte aus einem Substrat, mit den Schritten: Belichten des Substrats zu einem Bild (1) von einem Ausrichtungsmuster (A1, A2, A3) durch Abtasten des Substrats mit einem Elektronenstrahl oder einem Lichtstrahl; anschließendes Belichten des Substrats zu einem Bild von einem Objektmuster (B) durch Abtasten des Substrats mit einem Elektronenstrahl oder einem Lichtstrahl; und Wiederholen des Schrittes des Belichtens des Substrats zu einem Bild (2) von dem Ausrichtungsmuster (A1, A2, A3), wodurch zwei Bilder (1, 2) des Ausrichtungsmusters, die die gleiche Ausgestaltung haben, in einer zumindest teilweise überlagerten Beziehung auf dem Substrat belichtet sind, so daß die beiden Bilder (1, 2) des Ausrichtungsmusters in einer Richtung relativ zueinander verschoben sind und einen Abstand haben, der dem kumulativen Positionsfehler entspricht, der in dem Abtastsystem während der Abtastvorgänge auftritt, durch welche das Substrat zu den Bildern (1, 2, B) belichtet wird, wodurch Positionsabweichungen zwischen dem Ausrichtungsmuster und dem Objektmuster minimiert werden.

2. Verfahren nach Anspruch 1, bei dem die Form und die Ausgestaltung der Bilder des Ausrichtungsmusters so ist, daß in einer fertigen Musterplatte die überlagerten Ausrichtungsmuster ein zusammengesetztes Ausrichtungsmuster bilden, aus dem ein Positionsfehler bezüglich des Objektmusters bestimmt werden kann, der einem Mittelwert des kumulativen Fehlers entspricht.

3. Verfahren nach Anspruch 1 oder 2, bei dem der Schritt des Belichtens des Substrats zu einem Bild des Ausrichtungsmusters ebenfalls zumindest einmal während des Schrittes des Belichtens des Substrats zu dem Bild des Objektmusters wiederholt wird, wodurch zumindest drei Bilder eines Ausrichtungsmusters in einer zumindest teilweise überlagerten Beziehung in der fertigen Musterplatte gebildet werden.

4. Verfahren nach einem der Ansprüche 1 - 3, bei dem die durch das Verfahren hergestellte Musterplatte eine Platte eines Zwischenmasken-Musters ist.

5. Verfahren nach einem der Ansprüche 1 - 3, bei dem die durch das Verfahren hergestellte Musterplatte eine Platte eines Lochmasken-Musters ist.

6. Verfahren nach einem der Ansprüche 1 - 3, bei dem die durch das Verfahren hergestellte Musterplatte eine Elektrodenmusterplatte für eine Flüssigkristall-Anzeige ist.

**Revendications**

1. Procédé pour produire une plaque modèle à partir d'un substrat, comprenant les étapes suivantes : exposer le substrat à une image (1) d'une cible d'alignement (A1, A2, A3) en balayant ledit substrat avec un faisceau d'électrons ou un faisceau lumineux ; exposer ensuite ledit substrat à une image d'un modèle de dispositif (B) en balayant ledit substrat avec un faisceau d'électrons ou un faisceau de lumière ; et répéter l'étape d'exposition dudit substrat à une image (2) de ladite cible d'alignement (A1, A2, A3), d'où il résulte que les deux images (1, 2) desdites cibles d'alignement ayant la même configuration sont exposées sur ledit substrat en une relation au moins partiellement superposée, de telle sorte que les dites deux images (1, 2) de ladite cible d'alignement sont relativement déplacées dans une direction et d'une distance correspondant à l'écart cumulatif en position apparaissant dans le système de balayage pendant les opérations de balayage dans lesquelles ledit substrat est exposé auxdites images (1, 2, B) minimisant ainsi les écarts de position entre la cible d'alignement et le modèle de dispositif.

2. Procédé selon la revendication 1, dans lequel la forme et la configuration desdites images de ladite cible d'alignement sont telles que, dans une plaque modèle terminée, les cibles d'alignement superposées forment une cible d'alignement composite dont on peut déterminer un écart de position en relation avec ledit modèle de dispositif qui représente une valeur moyenne dudit écart cumulé.

3. Procédé selon la revendication 1 ou la revendication 2, dans lequel l'étape dans laquelle on expose ledit substrat à une image de ladite cible d'alignement est également répétée au moins une fois pendant l'étape dans laquelle on expose le substrat à ladite image du modèle de dispositif, d'où il résulte qu'au moins trois images d'une cible d'alignement sont formées dans une relation au moins partiellement superposée dans la plaque modèle terminée.

4. Procédé selon l'une des revendications 1 à 3, dans lequel la plaque modèle formée par le procédé est une plaque d'un modèle de réticule.

5. Procédé selon l'une des revendications 1 à 3, dans lequel la plaque modèle formée par le procédé est une plaque d'un modèle de masque perforé.

6. Procédé selon l'une des revendications 1 à 3, dans lequel la plaque modèle formée par le procédé est une plaque modèle d'électrode pour un panneau à cristaux liquides.

FIG. 1

Exposing order : A1, A2, A3→B→A1, A2, A3

FIG. 2

FIG. 3

## FIG. 4

$$M+\frac{\sigma}{2}+\Sigma$$

$W_1$